# EUROPEAN PATENT APPLICATION

(11) **EP 3 945 754 A1**
(43) Date of publication of application: **02.02.2022**
(21) Application number: 20188771.8
(22) Date of filing: 30.07.2020
(51) Int. Cl.: H05K 3/32, H01R 13/22

(54) **CONTACT RETAINER FOR AN INTEGRATED CIRCUIT**

(71) Applicant: Valeo Systèmes d'Essuyage, 78322 Le Mesnil Saint Denis (FR)
(72) Inventor: KAPITZA, Harald, 74321 Bietigheim-Bissingen (DE); SUESSER, Karl Heinz, 74321 Bietigheim-Bissingen (DE); STEFANI, Siegfried, 74321 Bietigheim-Bissingen (DE); TAKI, Jad, 93012 BOBIGNY (FR); ZHOU, An, 93012 BOBIGNY (FR)
(74) Representative: Valeo Visibility

(57) **Abstract**

The invention is referred to a contact retainer for an integrated circuit, comprising a flat portion (2) centred by an orifice (3) formed by spring elements (5) and adapted to receive an electrical conductor through the orifice (3) and to form a resilient contact between the electrical conductor (12) and the contact retainer (1), the flat portion (2) comprising a first plurality of recess areas (4) disposed in a symmetrical arrangement with respect to the orifice (3).

## Description

### TECHNICAL FIELD

The present invention concerns the domain of electronic component for an integrated circuit, and concerns more specifically contact retainer for an integrated circuit.

### STATE OF THE ART

The integrated level of electronic integrated circuits are growing higher every year. In order to satisfy this challenging request, it is well known that the physical dimension of electronic components has been scaled down. For the same reason, the physical distance between electronic components in an integrated circuit also has to be greatly reduced.

In general, a contact retainer for an integrated circuit is designed to provide a reliable electrical contact between an electrical conductor, such as an electrical wire, and an electrical pin of an integrated circuit.

However, such electrical conductor needs often to be soldered to the contact retainer to ensure a good electrical contact, which requires extra manufacture step and is not very practical for some electrical devices requiring a manual quick installation.

Furthermore, a contact retainer is often disposed in an isolated way in an integrated circuit. In other words, the distance between the contact retainer and other electrical components is generally greater than the average inter-component distance in the integrated circuit. The footprint of such integrated circuit is often not optimised.

There is thus a need to provide a low-complexity and space saving technical solution that makes it possible to ensure not only the reliable electrical contact between an electrical conductor and a contact retainer in an easier and more flexible way but also a reduced footprint of the integrated circuit.

### DESCRIPTION OF THE INVENTION

The invention provides a solution for solving at least partially this problem by the provision of a contact retainer according to claim 1. Preferred embodiments of the invention are defined in dependent claims.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

According to one aspect, a contact retainer for an integrated circuit is proposed. The contact retainer comprise a flat portion centred by an orifice formed by spring elements and adapted to receive an electrical conductor through the orifice and to form a resilient contact between the electrical conductor and the contact retainer. The flat portion comprises a first plurality of recess areas disposed in a symmetrical arrangement with respect to the orifice.

Such contact retainer for an integrated circuit allows advantageously a resilient contact for ensuring an easy and reliable electrical contact between the electrical conductor and the contact retainer, especially for the integrated circuit which requires a manual installation.

Moreover, the contact retainer comprises several recess areas adapted for receiving other electrical components of the integrated circuit once installed in the integrate circuit. Advantageously, the symmetrical arrangement of these recess areas allows obtaining an equal minimal distance between the centre of the contact retainer for receiving the electrical conductor and each of other possible electrical components disposed around the contact retainer.

In this way, the global footprint of the contact retainer respect to other electrical components can be advantageously reduced for obtaining a space saving integrated circuit, which is especially useful for applications with restricted space.

According to one embodiment, the spring elements comprise at least two metallic lips bent towards the centre of the orifice.

The bent metallic lips can securely hold the electrical conductor, such as an electrical wire, once inserted in the orifice and provide a good electrical contact between the electrical conductor and the contact retainer.

The spring elements can for example comprise four metallic lips.

According to another embodiment, the spring elements comprise a closed metallic contour forming an auxiliary orifice smaller than the orifice.

According to one embodiment, the flat portion comprises further a second plurality of gaps disposed in a symmetrical arrangement with respect to the orifice.

As a non-limitative example, the second plurality of gaps can be used to indicate and calibrate emplacement of the contact retainer in the integrated circuit.

The first plurality of recess areas and the second plurality of gaps can for example be disposed together in a symmetrical arrangement with respect to the orifice.

The number of the first plurality of recess areas and the number of the second plurality of the gaps can for example be equal.

The flat portion can comprise for example four recess areas and four gaps. Each recess area can for example be disposed between two adjacent gaps and form an angle of 45° with each of the two adjacent gaps with respect to the orifice.

According to another aspect, an integrated circuit is proposed.

The integrated circuit comprises
at least one contact retainer as defined above,
a common substrate having a first layer attached to the flat portion of the at least one contact retainer, and at least one hole traversing at least the first layer and receiving the spring elements of the at least one contact retainer, and
a third plurality of electronic components, each of the electronic components being disposed at least partially in a recess area of the corresponding contact retainer.

According to one embodiment, the number of the third plurality of electronic components and the number of the first plurality of the recess areas are equal and each electronic component is disposed at least partially in its corresponding recess area.

Advantageously, such symmetrical arrangement of the electronic components allows reducing distances between the contact retainer and these electronic components so as to reduce the global footprint of the contact retainer.

In a non-limitative example, the third plurality of the electronic components are surface mounted devices.

According to one embodiment, the minimal distance between each electronic component and its corresponding recess area is at least 0.5 mm, and the minimal distance between each electronic component and an electronic conductor when the electronic conductor is inserted in the orifice is 1.74 mm.

The common substrate can for example be a printed circuit board comprising at least a first layer to route the third plurality of electronic components and the at least one contact retainer, and at least a second layer.

According to one aspect, an electronic device is proposed. The electronic device comprises an integrated circuit as defined above and a metallic plat electrically connected to the second layer.

According to another aspect, a direct current DC motor arrangement for an automotive wiper is also proposed. The DC motor comprises an electronic device as defined above.

According to one embodiment, the DC motor arrangement comprising further a first portion of a housing and a second portion of a housing; and a DC motor located inside the first portion of the housing, the DC motor comprising a first power line and a second power line.

The electronic device comprises a first contact retainer connected in series with the first power line, a second contact retainer connected in series with the second power line, a first portion of the metallic plate connected to the electronic components disposed in the recess areas of the first contact retainer, and a second portion of the metallic plate connected to the electronic components disposed in the recess areas of the second contact retainer.

The first portion and the second portion are respectively and electrically connected in series to the second portion of the housing.

Such arrangement with the metallic plate electrically connected to the second portion of the housing forms advantageously an electromagnetic cage, commonly known as Faraday cage or Faraday shield, for shielding the electromagnetic noise generated by the DC motor. As a result, the electromagnetic compatibility (EMC) performance of the DC motor arrangement can be improved.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a general view of an example of contact retainer according the invention.
Figure 2 shows a general view of another example of contact retainer according the invention.
Figure 3 shows a front view of an integrated circuit comprising an example of contact retainer according to the invention.
Figure 4 shows an example of electronic device according to the invention.
Figure 5 shows an example of DC motor arrangement according to the invention.

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

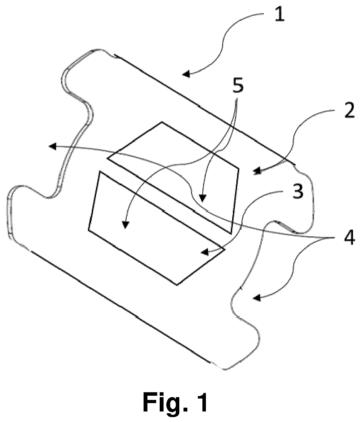

The reference 1 in figure 1 represents an example of contact retainer for an integrated circuit according the invention.

The contact retainer 2 is electrically conductive and comprises a flat portion 2 centred by an orifice 3, and a first plurality of access areas 4, here for example two access areas, disposed in a symmetrical arrangement with respect to the orifice 3.
The orifice 3 can have any kind of form and have for example a hexagonal form here as illustrated in figure 1.

The contact retainer 1 comprises further spring elements 5 forming the orifice 3 and having at least two metallic lips, here for example two metallic lips, bent towards the centre of the orifice 3. These metallic lips are deformable and relatively elastic.

The orifice 3 is intended to receive an electrical conductor such as an electrical wire. When the electrical conductor is inserted through the orifice 3, the spring elements 5 are pressed by the electrical conductor and form then a resilient contact between the electrical conductor and the contact retainer. As a result, such contact retainer can provide advantageously a reliable electrical contact between the electrical conductor and the contact retainer in an easier way without further need of an extra fixation process such as a soldering process.

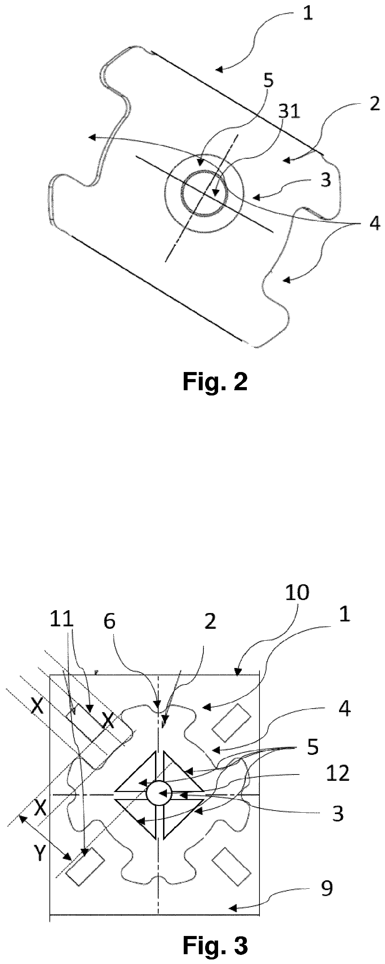

Figure 2 illustrates a general view of another example of contact retainer according to the invention.

The contact retainer 1 is the same as the one presented in figure 1 expect for the spring elements 5 forming the orifice 3. In this example, the spring elements 5 comprise a closed metallic contour forming an opening 31 smaller than the orifice 3.

As a non-limitative example, all the orifice 3 and the opening 31 have a round form. The closed metallic contour 5 is slightly protruded from one side of the contact retainer 1 and forms the opening 31 having a dimension smaller than the one of the orifice 3.

Advantageously, when an electrical conductor, having a dimension smaller than that of the orifice 3 but slightly greater than the one of the opening 31, is inserted through the orifice and the opening, the electrical conductor can be securely held by the closed metallic contour 5 so as to ensure a good electrical contact between the contact retainer and the electrical conductor.

Figure 3 illustrates a front view of another example of contact retainer according to the invention.

In this example, the contact retainer 1 comprises a flat portion 2 centred by an orifice 3 formed by four metallic lips 5 bent toward the centre of the orifice 3. The flat portion 2 comprises four recess areas 4 and a second plurality of gaps 6, here for example also fours gaps, disposed in a symmetrical arrangement with respect to the orifice 3.

In this embodiment, the recess areas 4 and the gaps 6 are arranged in the same symmetrical way with respect to the orifice 3. In other words, every two adjacent recess areas or every two adjacent gaps forms an angle of 90° with respect to the center of the orifice 3. Every recess area 4 forms an angle of 45° with its adjacent gap 6.

For an indicative but non limitative purpose, the gaps 6 can be used here as directional markers for the implantation in an integrated circuit.

The contact retainer 2 is deposited on a substrate 9 for an integrated circuit. The flat portion 2 of the contact retainer 2 is electrically connected, for example soldered, to the substrate 9.

Four electronic components 11 are also deposited on the substrate 9 and each of these electronic components is disposed at least partially in a recess area 4.

It is worth noting that the minimal distance between each electronic component and its corresponding recess area is at least 0.5 mm and the minimal distance between each electronic component and an electronic conductor 12 when the electronic conductor 12 is inserted in the orifice is 1.74 mm.

In such way, the physical distance between the electrical conductor when it is inserted in the orifice and any one of these electronic components 11 is reduced so as to lower the footprint of the contact retainer 1.

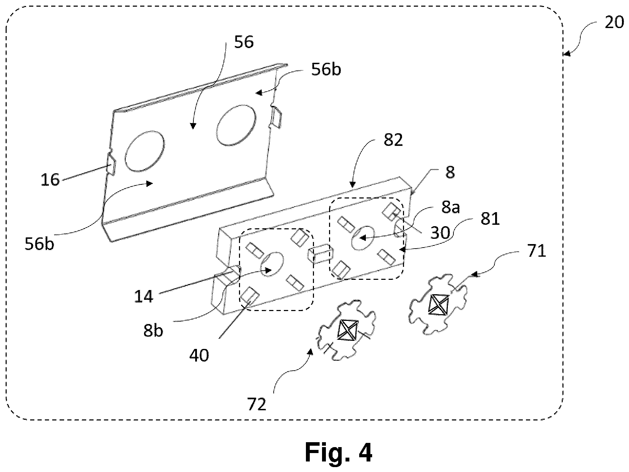

Figure 4 illustrates an electronic application example of at least a contact retainer 1 as shown in the figure 3. This electronic application is for example a filter unit 20 used in a DC motor arrangement.

The reference 8 represents a printed circuit board 8 comprises a first layer, here a front layer 81 and at least a second layer, here a back layer 82.

The filter unit 20 comprises
a first filter means 30 comprising for example four capacitors,
a second filter means 40 comprising also four capacitors,
a first contact retainer 71 and a second contact retainer 72 which are soldered to the front layer 81 to route the capacitors of the first and second filter means 30, 40.

Each of the first and second contact retainer 71, 72 is the same contact retainer 1 as shown in figure 3. The capacitors of the first and second filter means 30, 40 are arranged in the same way of the electrical components 11 as shown in figure 3.

All the capacitors comprised in the first and second filter means 30, 40 are multi-Layer ceramic capacitors (MLCC) designed as surface mounted device (SMD), which provide a good packaging size and a low parasitic inductance.

The filter unit 20 comprises further a metallic plate 56 electrically connected to the back layer 82 of the printed chip board 8. The first and second filter means 30, 40 are respectively connected to a first portion 56a and a second portion 56b of the metallic plate 56.

The metallic plate 56 is intended to be soldered to the back layer 82 of the printed circuit board 8. The printed circuit board 8 comprises at least a notch 14 to receive a corresponding protrusion 16 of the metallic plate 56. This interconnection between the protrusion 16 and the notch 14 is useful in the soldering process of the metallic plate 56 to the back layer 82 of the printed circuit board 8, where an attachment is required to avoid undesired displacement of the metallic plate 56 with respect to the printed circuit board 8.

The printed circuit board 8 comprises further a first hole 8a and a second hole 8b traversing at least the front layer 81 and receiving the spring elements 5 of the first and second contact retainer 71, 72.

Each contact retainer 71, 72 has an orifice 15a, 15b to receive a corresponding DC motor power line and arranged to hold the corresponding DC motor power line in a tight manner, thus connecting each DC motor power line to the corresponding filter means 30, 40.

Such filter unit 20 comprising the first and second contact retainer 30, 40 is especially adapted to applications with restricted space.

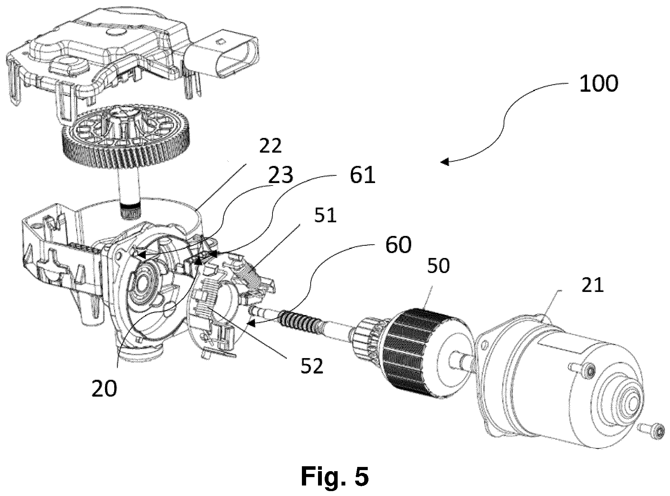

Now we refer to figure 5 to illustrate a DC motor arrangement for an automotive wiper comprising a filter unit 20 as shown in figure 4.

The DC motor arrangement 100 comprises
a first portion of a housing 21, here for example a gear housing, and a second portion of a housing 22, here for example a motor housing;
a DC motor 50 intended to be located inside the first portion of the housing 21,
a filter unit 20 associated to the DC motor 50 to reduce the electromagnetic noise caused by this DC motor 50.

The DC motor arrangement 100 comprises further a brush card 60, a first inductor 51, a second inductor 52, a first power line and a second power line of the DC motors 50.

The brush card 60 comprises a slot 61 where the filter unit 20 is housed. A portion of this brush card 60, comprising the slot 61, is intended to be inserted in an opening 23 of the gear housing 22. The metallic plate 56 of the filter unit 20 partially closes this opening 23 by making contact with the second portion of the housing 22.

The metallic plate 56, the second portion of the housing 22 together with the first portion of the housing 21 form thus an electromagnetic shield, commonly known as Faraday shield or Faraday cage, of the DC Motor 50 so as to improve the electromagnetic compatibility EMC performance of the DC motor arrangement 100.

## Claims

1. Contact retainer for an integrated circuit, comprising a flat portion (2) centred by an orifice (3) formed by spring elements (5) and adapted to receive an electrical conductor through the orifice (3) and to form a resilient contact between the electrical conductor (12) and the contact retainer (1), the flat portion (2) comprising a first plurality of recess areas (4) disposed in a symmetrical arrangement with respect to the orifice (3).

2. Contact retainer according to claim 1, wherein the spring elements (5) comprise at least two metallic lips bent towards the centre of the orifice (3).

3. Contact retainer according to claim 2, wherein the spring elements (5) comprise four metallic lips.

4. Contact retainer according to claim 1, wherein the spring elements (5) comprise closed metallic contour forming an opening smaller than the orifice (3).

5. Contact retainer according to any of preceding claims, wherein the flat portion (2) comprises further a second plurality of gaps (6) disposed in a symmetrical arrangement with respect to the orifice (3).

6. Contact retainer according to claim 5, wherein the first plurality of recess areas (4) and the second plurality of gaps (6) are disposed together in a symmetrical arrangement with respect to the orifice (3).

7. Contact retainer according to claim 6, wherein the flat portion comprises four recess areas and four gaps, each recess area being disposed between two adjacent gaps and forming an angle of 45° with each of the two adjacent gaps with respect to the orifice.

8. Integrated circuit comprising
at least one contact retainer (1) according to any of preceding claims,
a common substrate (8) having a first layer (81) attached to the flat portion (2) of the at least one contact retainer (71, 72), and at least one hole traversing at least the first layer (81) and receiving the spring elements (5) of the at least one contact retainer (1), and
a third plurality of electronic components (30, 40), each of the electronic components (30, 40) being disposed at least partially in a recess area (4) of the corresponding contact retainer (1).

9. Integrated circuit according to claim 8, wherein the number of the third plurality of electronic components (30, 40) and the number of the first plurality of the recess areas (4) are equal, and each electronic component (30, 40) being disposed at least partially in its corresponding recess area (4).

10. Integrated circuit according to any of claims 8 and 9, wherein the third plurality of electronic components (30, 40) are surface mounted devices.

11. Integrated circuit according to claim 10, wherein minimal distance (X) between each electronic component and its corresponding recess area is at least 0.5 mm, and wherein the minimal distance (Y) between each electronic component and an electronic conductor when the electronic conductor is inserted in the orifice is 1.74 mm.

12. Integrated circuit according to any of claims 8 to 11, wherein the common substrate (8) is a printed circuit board comprising at least a first layer (81) to route the third plurality of electronic components (11) and the at least one contact retainer (71, 72), and at least a second layer (82).

13. Electronic device comprising an integrated circuit according to claim 12, and a metallic plate (56) electrically connected to the second layer (82).

14. DC motor arrangement for an automotive wiper comprising an electronic device (20) according to claim 13.

15. DC motor arrangement according to claim 14, comprising further
a first portion of a housing (21) and a second portion of a housing (22); and
a DC motor (50) located inside the first portion of the housing (21), the DC motor (50) comprising a first power line and a second power line; and
wherein the electronic device (20) comprises
a first contact retainer (71) connected in series with the first power line, a second contact retainer (71) connected in series with the second power line;
a first portion of the metallic plate (56) connected to the electronic components (20) disposed in the recess areas of the first contact retainer (71),
a second portion of the metallic plate (56) connected to the electronic components (20) disposed in the recess areas of the second contact retainer (72); and
wherein the first portion and the second portion (56a, 56b) are respectively and electrically connected in series to the second portion of the housing (21, 22).
